# EUROPEAN PATENT APPLICATION

(11) **EP 1 843 468 A1**
(43) Date of publication of application: **10.10.2007**
(21) Application number: 06700900.1
(22) Date of filing: 12.01.2006
(51) Int. Cl.: H03J 7/18, H04B 1/26

(54) **RADIO COMMUNICATION EQUIPMENT**

(30) Priority: 12.01.2005 JP 2005005368
(71) Applicant: NEC Corporation, Minato-ku Tokyo 108-8001 (JP)
(72) Inventor: AKIYA, Makoto c/o NEC Saitama, Ltd. 300-18, Aza Toyohara, Saitama (JP)
(74) Representative: Glawe, Delfs, Moll
(86) International application number: PCT/JP2006/300670
(87) International publication number: WO 2006/075779

(57) **Abstract**

A PLL circuit (11) is provided with an oscillator for reception at a frequency band (A), and an oscillator for reception at a frequency band (B). A PLL circuit (12) is provided with an oscillator for reception at the frequency band (B), and an oscillator for reception at the frequency band (A). In the case of searching at the frequency band (A), the PLL circuit (11) and the PLL circuit (12) are oscillated at different frequencies within the frequency band (A) at the same time. After locking the PLL circuit (11), output from the PLL circuit (11) is inputted to a mixer (15) and an intensity of a receiving signal is measured, then, a signal to be inputted to the mixer (15) is switched to an output from the PLL circuit (12) and an intensity of a receiving signal is measured.

## Description

### Technical Field

This invention relates to a radio communication device and, more specifically, relates to a radio communication device capable of receiving signals of a plurality of frequency bands.

### Background Art

There are known radio communication devices each capable of receiving/transmitting signals in a plurality of frequency bands (e.g. Japanese Unexamined Patent Application Publication (JP-A) No. Hei 2-309712). For example, in the case of mobile phones, use is made of a mobile phone capable of communicating in a 1.5GHz band in addition to an 800MHz band.

In recent years, the development of mobile phones has been remarkable and users of mobile phones have been increasing. Following this, free frequencies (free channels) are in short supply particularly in cities and it has thus been getting difficult to ensure call quality. In the case where a mobile phone is configured to be capable of communicating in a plurality of frequency bands, even if there is no free frequency in a certain frequency band, if there is a free frequency in another frequency band, communication can be performed using the free frequency in such another frequency band. Accordingly, the number of usable channels can be increased and thus the call quality can be ensured.

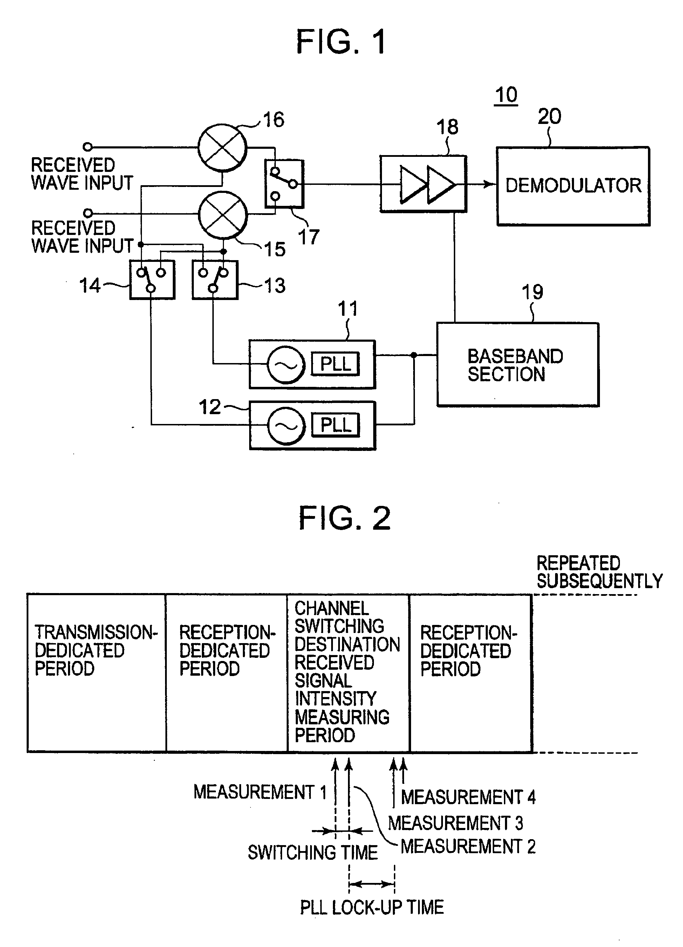

Fig. 1 shows the configuration of a conventional mobile phone adapted to a plurality of frequency bands. Fig. 2 shows, in the form of a timing chart, the operation of the mobile phone shown in Fig. 1.

In Fig. 1, a mobile phone 50 has two PLL (Phase-Locked Loop) circuits 51 and 52. The PLL circuit 51 oscillates, for example, in an 800MHz band, while, the PLL circuit 52 oscillates, for example, in a 1.5GHz band. As shown in Fig. 2, the mobile phone 50 has, as operation time periods, a transmission-dedicated period, a reception-dedicated period, and a channel switching destination received signal intensity measuring period. In the transmission-dedicated period and the reception-dedicated period, the mobile phone 50 performs reception and transmission using the 800MHz band or the 1.5GHz band. When performing communication in the 800MHz band, the mobile phone 50 supplies a signal of the 800MHz band to a mixer 55 from the PLL circuit 51 in the reception-dedicated period shown in Fig. 2. The mixer 55 produces an intermediate frequency based on a received signal and the signal of the 800MHz band from the PLL circuit 51 and inputs it to an IF (Intermediate Frequency) amplifier 58 through a switch 57. The IF amplifier 58 amplifies the intermediate frequency and outputs it to a demodulator 60 and, further, notifies a signal intensity of the received signal to a baseband section 59.

In the channel switching destination received signal intensity measuring period, the mobile phone 50 searches the 800MHz band or the 1.5GHz band in the following manner. When searching the 800MHz band, the PLL circuit 51 is caused to oscillate at an oscillation frequency in the 800MHz band and it is input to the mixer 55. An intermediate frequency obtained by the mixer 55 is input to the IF amplifier 58 through the switch 57. The IF amplifier 58 notifies a signal intensity of a received signal to the baseband section 59. Thereafter, the oscillation frequency of the PLL circuit 51 is changed to a next frequency and a received signal intensity at that frequency is measured. The operation as described above is repeated. On the other hand, when searching the 1.5GHz band, the mobile phone 50 changes an oscillation frequency of the PLL circuit 52 and, through the same operation as described above, measures received signal intensities at respective frequencies. If, as a result of the search, there is a frequency with a received signal intensity higher than a received signal intensity in the reception-dedicated period, the frequency for use in transmission and reception is switched to the frequency with the higher received signal intensity in accordance with a command from the baseband section 59.

### Disclosure of the Invention

### Problem to be Solved by the Invention:

Incidentally, in the mobile phone 50, when changing the oscillation frequency to a next frequency after measurement of a received signal intensity in the channel switching destination received signal intensity measuring period, it is necessary to again lock the PLL circuit 51 or the PLL circuit 52 to the next frequency. Therefore, as shown in Fig. 2, in consideration of a lock-up time of the PLL circuit, the received signal intensities can be measured only at a limited number of frequencies in the channel switching destination received signal intensity measuring period. It is possible to increase the number of examinable frequencies by shortening the lock-up time of the PLL circuit. However, in that case, it is known that the C/N characteristics of signals output from the PLL circuit are degraded and, thus, there is a demand for a new technique that can measure more received signal intensities in a limited time.

It is an object of this invention to provide a radio communication device that can measure received signal intensities at more frequencies in a limited time.

### Means for Solving the Problem:

This invention is applied to a radio communication device capable of communicating in at least a first frequency band and a second frequency band.

A radio communication device according to a first aspect of this invention comprises a first and a second PLL circuit each capable of oscillating at frequencies in a first and a second frequency band, a first mixer adapted to receive an output signal at a frequency in the first frequency band from the first or second PLL circuit through a switch and to produce an intermediate frequency based on the output signal received from the PLL circuit and a received signal, a second mixer adapted to receive an output signal at a frequency in the second frequency band from the first or second PLL circuit through a switch and to produce an intermediate frequency based on the output signal received from the PLL circuit and a received signal, and a measuring circuit adapted to receive the intermediate frequency produced by the first mixer or the second mixer and to measure a signal intensity of the received signal. This radio communication device is characterized in that the first and second PLL circuits are caused to oscillate at different frequencies in one of the first and second frequency bands and output frequencies of both of the oscillating PLL circuits are input to one of the first and second mixers by switching the output frequencies in order, thereby measuring received signal intensities at a plurality of channels in the same frequency band in order.

A radio communication device according to a second aspect of this invention comprises a first and a second PLL circuit each capable of oscillating at frequencies in a first and a second frequency band, a first mixer adapted to receive an output signal at a frequency in the first frequency band from the first or second PLL circuit through a first switch and to produce an intermediate frequency based on the output signal received from the PLL circuit and a received signal, a second mixer adapted to receive an output signal at a frequency in the second frequency band from the first or second PLL circuit through a second switch and to produce an intermediate frequency based on the output signal received from the PLL circuit and a received signal, and a measuring circuit adapted to receive the intermediate frequency produced by the first mixer or the second mixer and to measure a signal intensity of the received signal. According to this radio communication device, in a received signal intensity measuring period, the first and second PLL circuits are caused to oscillate at different frequencies in one of the first and second frequency bands and output frequencies of both of the oscillating PLL circuits are input to one of the first and second mixers in order, so that the measuring circuit measures received signal intensities at a plurality of channels in the same frequency band in order.

In the radio communication device according to the second aspect, the measuring circuit is realized by an IF amplifier adapted to amplify the intermediate frequency output from the first mixer or the second mixer and to input an amplified signal to a demodulator. In this case, the IF amplifier is further adapted to measure a received signal intensity based on the intermediate frequency output from the first mixer or the second mixer and to input a DC voltage indicative of the measured received signal intensity to a baseband section.

The radio communication device according to the second aspect has, as operation time periods, at least a reception-dedicated period and a channel switching destination received signal intensity measuring period. In this case, the baseband section makes a comparison between a received signal intensity at a currently used frequency, measured in the reception-dedicated period, and a received signal intensity measured in the channel switching destination received signal intensity measuring period. If judging that the received signal intensity measured in the channel switching destination received signal intensity measuring period is greater than the received signal intensity measured in the reception-dedicated period, the baseband section sends a channel switching signal to the first PLL circuit or the second PLL circuit, thereby performing channel switching to a frequency with the greater received signal intensity.

### Effect of the Invention:

In the radio communication device according to this invention, the first PLL circuit and the second PLL circuit are both used in each of the cases of measuring signal intensities of received signals in the first frequency band and of measuring signal intensities of received signals in the second frequency band. Therefore, as compared with the conventional radio communication device that searches for a frequency with a higher received signal intensity using one of the PLL circuits, search can be accelerated and thus the received signal intensities at more frequencies can be measured in a limited time. Accordingly, it is possible to quickly shift to a channel with a higher received signal intensity to thereby maintain high call quality.

### Brief Description of the Drawings

Fig. 1 is a block diagram showing the configuration of a conventional radio communication device adapted to a plurality of frequency bands.
Fig. 2 is a timing chart for explaining operation time periods of the conventional radio communication device.
Fig. 3 is a block diagram showing the configuration of a radio communication device according to an embodiment of this invention.
Fig. 4 is a timing chart for explaining operation time periods of the radio communication device according to the embodiment of this invention.

### Best Mode for Carrying Out the Invention

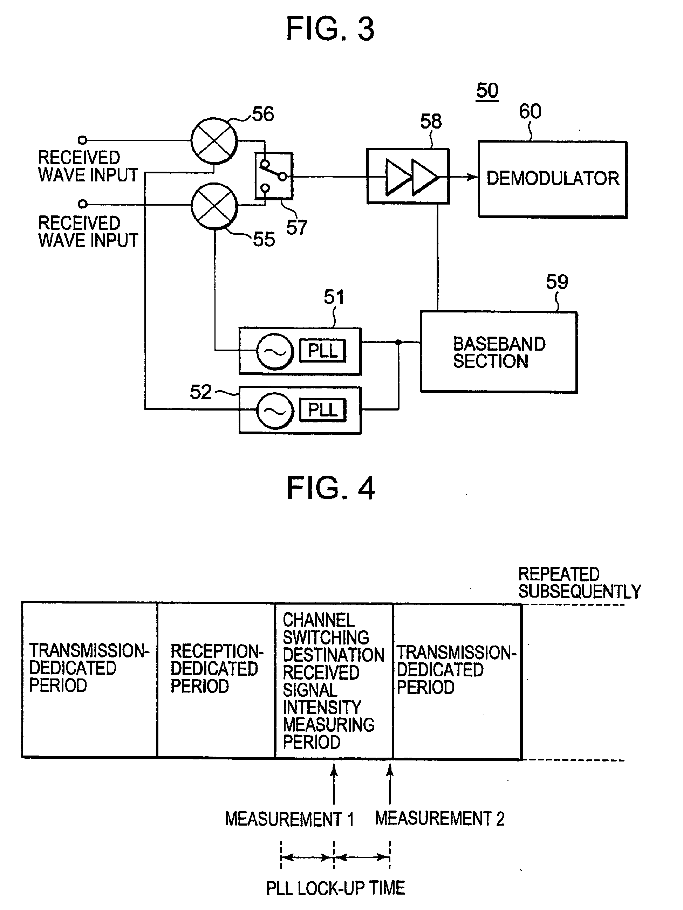

Referring to Figs. 3 and 4, an embodiment of this invention will be described in detail. Fig. 3 shows part of a radio communication device according to the embodiment of this invention. A radio communication device 10 comprises PLL circuits 11 and 12, switchs 13, 14, and 17, mixers 15 and 16, an IF amplifier 18, a baseband section 19, and a demodulator 20. The radio communication device 10 is configured as a mobile phone adapted to a plurality of frequency bands. Hereinbelow, a description will be given of a case where signal transmission/reception is carried out using a frequency band A or a frequency band B.

The PLL circuit 11 is used when receiving a signal of the frequency band A at the time of communication. The PLL circuit 12 is used when receiving a signal of the frequency band B at the time of communication. The PLL circuit 11 has an oscillator for reception in the frequency band A and further has an oscillator for reception in the frequency band B. The PLL circuit 12 has an oscillator for reception in the frequency band B and further has an oscillator for reception in the frequency band A. The switch 13 inputs an output of the PLL circuit 11 to the mixer 15 or the mixer 16 by switching between them. The switch 14 inputs an output of the PLL circuit 12 to the mixer 15 or the mixer 16 by switching between them.

The mixer 15 is configured as a mixer for the frequency band A and, in response to receipt of a frequency signal of the frequency band A output from the PLL circuit 11 or the PLL circuit 12 and a received signal, outputs an intermediate frequency. The mixer 16 is configured as a mixer for the frequency band B and, in response to receipt of a frequency signal of the frequency band B output from the PLL circuit 11 or the PLL circuit 12 and a received signal, outputs an intermediate frequency. The switch 17 inputs the intermediate frequency output from the mixer 15 or the mixer 16, to the IF amplifier 18. The IF amplifier 18 amplifies the intermediate frequency and inputs it to the demodulator 20. The IF amplifier 18 also has a function of a measuring circuit. It measures a received signal intensity based on the intermediate frequency output from the mixer 15 or the mixer 16 and inputs a DC voltage indicative of the measured received signal intensity to the baseband section 19. The baseband section 19 carries out a predetermined operation including a voltage comparison operation, thereby performing switching of a channel to be used in communication.

Fig. 4 shows the operation of the radio communication device according to the embodiment of this invention in the form of a timing chart. The radio communication device 10 has, as operation time periods, a transmission-dedicated period for transmitting a radio signal, a reception-dedicated period for receiving a radio signal, and a channel switching destination received signal intensity measuring period for measuring received signal intensities at channel switching destinations, in the order named. When the received signal intensity is reduced and thus the call quality is lowered in the reception-dedicated period, the radio communication device 10 monitors received signal intensities at channel switching destinations. Then, when a received signal intensity higher than the received signal intensity in the reception-dedicated period is obtained at a certain channel (frequency), channel switching to that channel is performed quickly.

In the case where the radio communication device 10 performs radio communication in the frequency band A, a signal for reception in the frequency band A output from the PLL circuit 11 is input to the mixer 15 through the switch 13 in the reception-dedicated period. The mixer 15 multiplies together the signal for reception in the frequency band A and a received signal and outputs an intermediate frequency. The switch 17 is selecting the output of the mixer 15 in accordance with a band selection signal. The IF amplifier 18 receives the intermediate frequency through the switch 17, amplifies the received intermediate frequency, and outputs it to the demodulator 20. Further, the IF amplifier 18 outputs a received signal intensity of the signal received in the reception-dedicated period to the baseband section 19 in the form of a DC voltage.

In the case where the radio communication device 10 performs radio communication in the frequency band B, a signal for reception in the frequency band B output from the PLL circuit 12 is input to the mixer 16 through the switch 14 in the reception-dedicated period. The switch 17 is selecting an output of the mixer 16 in accordance with a band selection signal. An intermediate frequency amplified by the IF amplifier 18 is input to the demodulator 20. On the other hand, a received signal intensity of a signal received in the reception-dedicated period is input to the baseband section 19. While radio communication is performed in the frequency band A, the radio communication device 10 stops the operation of the PLL circuit 12 to thereby minimize the power consumption. On the other hand, while radio communication is performed in the frequency band B, the radio communication device 10 stops the operation of the PLL circuit 11 to thereby minimize the power consumption.

In the channel switching destination received signal intensity measuring period, when it becomes necessary to measure received signal intensities at a plurality of frequencies in accordance with a command from a base station, the radio communication device 10 simultaneously operates the PLL circuit 11 and the PLL circuit 12. By this, two oscillation frequencies respectively corresponding to two received signals requiring measurement of received signal intensities are simultaneously produced. For example, when measuring received signal intensities of a received wave Ra (frequency Fa) and a received wave Rb (frequency Fb) in the frequency band A, the PLL circuit 11 is oscillated/locked at an oscillation frequency Fa corresponding to the received wave Ra and the PLL circuit 12 is oscillated/locked at an oscillation frequency Fb corresponding to the received wave Rb.

After the PLL circuit 11 is locked, the mixer 15 receives the oscillation frequency Fa through the switch 13 and multiplies it by the received wave Ra to thereby produce an intermediate frequency. The produced intermediate frequency is input to the IF amplifier 18 through the switch 17 and a received signal intensity of the received wave Ra is input to the baseband section 19. By this, "measurement 1" measuring the received signal intensity of the received wave Ra is carried out. After the completion of "measurement 1", the oscillation frequency Fb produced by the PLL circuit 12 is input to the mixer 15 through the switch 14, so that an intermediate frequency obtained by multiplication of the oscillation frequency Fb and the received wave Rb is input to the IF amplifier 18. By this, "measurement 2" measuring a received wave intensity of the received wave Rb is carried out.

After the completion of "measurement 2", the PLL circuit 11 is oscillated/locked at an oscillation frequency Fc corresponding to a received wave Rc and the PLL circuit 12 is oscillated/locked at an oscillation frequency Fd corresponding to a received wave Rd. After the PLL circuit 11 is locked, the oscillation frequency Fc output from the PLL circuit 11 is input to the mixer 15, thereby carrying out "measurement 3". After the completion of "measurement 3", the oscillation frequency Fd output from the PLL circuit 12 is input to the mixer 15, thereby carrying out "measurement 4".

Also in the case where channel switching destinations are located in the frequency band B, the radio communication device 10 performs the same operation as described above to oscillate/lock the PLL circuit 11 and the PLL circuit 12 at frequencies in the frequency band B and to input them to the mixer 16, thereby measuring received signal intensities.

The baseband section 19 makes a comparison between a received signal intensity (voltage value) at a currently used frequency, measured in the reception-dedicated period, and a received signal intensity (voltage value) measured in the channel switching destination received signal intensity measuring period. If it is judged that the received signal intensity measured in the channel switching destination received signal intensity measuring period is greater than the received signal intensity measured in the reception-dedicated period, the baseband section 19 sends a channel switching signal to the PLL circuit 11 or the PLL circuit 12 for performing communication using a frequency with the greater received signal intensity. As a result, switching is quickly made to a channel to be used in the reception-dedicated period and the transmission-dedicated period. This makes it possible to prevent degradation of call quality due to a reduction in received signal intensity.

According to the conventional radio communication device adapted to two frequency bands, in the channel switching destination received signal intensity measuring period, use is made of only the PLL circuit for the frequency band currently used in communication, while, use is not made of the PLL circuit for the frequency band other than such a currently used frequency band. According to this embodiment, the PLL circuit 11 and the PLL circuit 12 are each configured to be capable of oscillating in the frequency band A and the frequency band B and, in the channel switching destination received signal intensity measuring period, outputs of both the PLL circuits 11 and 12 are input to the mixer 15 or 16 by switching the PLL circuits 11 and 12 therebetween. Therefore, the received signal intensities at two frequencies can be measured only with a delay corresponding to a time required for switching the PLL circuit that inputs a signal to the mixer 15 or 16. According to this embodiment, as compared with the case where the frequency is changed in sequence using only one PLL circuit, the received signal intensities at more frequencies can be measured in a limited time. Therefore, according to this embodiment, it is possible to quickly shift to a channel with a higher received signal intensity to thereby maintain high call quality.

In the foregoing embodiment, there is shown the example where the radio communication device 10 is configured as the mobile phone, but not limited thereto, i.e. it can also be configured as a radio communication device other than the mobile phone. Further, there is shown the example where the radio communication device 10 is adapted to the two frequency bands, i.e. the frequency band A and the frequency band B, but not limited thereto, i.e. it can also be configured to be adapted to three or more frequency bands. In this case, when, for example, the radio communication device 10 is adapted to three frequency bands, search can be accelerated by searching using two or more of three PLL circuits each capable of producing signals for reception in the respective frequency bands.

While this invention has been described above in terms of the preferred embodiment, the radio communication device of this invention is not limited to the foregoing embodiment, but what are obtained by applying various modifications or changes to the structure of the foregoing embodiment are also included within the scope of this invention.

## Claims

1. A radio communication device capable of communicating in at least a first frequency band and a second frequency band, said radio communication device **characterized by** comprising:
a first and a second PLL circuit each capable of oscillating at frequencies in said first and second frequency bands;
a first mixer adapted to receive an output signal at a frequency in said first frequency band from said first or second PLL circuit through a switch and to produce an intermediate frequency based on the output signal received from said PLL circuit and a received signal;
a second mixer adapted to receive an output signal at a frequency in said second frequency band from said first or second PLL circuit through a switch and to produce an intermediate frequency based on the output signal received from said PLL circuit and a received signal; and
a measuring circuit adapted to receive the intermediate frequency produced by said first mixer or said second mixer and to measure a signal intensity of said received signal;
wherein said first and second PLL circuits are caused to oscillate at different frequencies in one of said first and second frequency bands and output frequencies of both of said oscillating PLL circuits are input to one of said first and second mixers by switching said output frequencies in order, thereby measuring received signal intensities at a plurality of channels in the same frequency band in order.

2. A radio communication device capable of communicating in at least a first frequency band and a second frequency band, said radio communication device **characterized by** comprising:
a first and a second PLL circuit each capable of oscillating at frequencies in said first and second frequency bands;
a first mixer adapted to receive an output signal at a frequency in said first frequency band from said first or second PLL circuit through a first switch and to produce an intermediate frequency based on the output signal received from said PLL circuit and a received signal;
a second mixer adapted to receive an output signal at a frequency in said second frequency band from said first or second PLL circuit through a second switch and to produce an intermediate frequency based on the output signal received from said PLL circuit and a received signal; and
a measuring circuit adapted to receive the intermediate frequency produced by said first mixer or said second mixer and to measure a signal intensity of said received signal;
wherein, in a received signal intensity measuring period, said first and second PLL circuits are caused to oscillate at different frequencies in one of said first and second frequency bands and output frequencies of both of said oscillating PLL circuits are input to one of said first and second mixers in order, so that said measuring circuit measures received signal intensities at a plurality of channels in the same frequency band in order.

3. A radio communication device according to claim 2,
**characterized in that** said measuring circuit is an IF amplifier adapted to amplify the intermediate frequency output from said first mixer or said second mixer and to input an amplified signal to a demodulator, said IF amplifier further adapted to measure a received signal intensity based on the intermediate frequency output from said first mixer or said second mixer and to input a DC voltage indicative of the measured received signal intensity to a baseband section.

4. A radio communication device according to claim 3, **characterized in that** said radio communication device has, as operation time periods, at least a reception-dedicated period and a channel switching destination received signal intensity measuring period, and
said baseband section makes a comparison between a received signal intensity at a currently used frequency, measured in said reception-dedicated period, and a received signal intensity measured in said channel switching destination received signal intensity measuring period and, if judging that the received signal intensity measured in said channel switching destination received signal intensity measuring period is greater than the received signal intensity measured in said reception-dedicated period, said baseband section sends a channel switching signal to said first PLL circuit or said second PLL circuit, thereby performing channel switching to a frequency with the greater received signal intensity.
